(19)

**Europäisches Patentamt**

**European Patent Office**

**Office européen des brevets**

(11) **EP 3 506 084 B1**

(12) **EUROPEAN PATENT SPECIFICATION**

(45) Date of publication and mention
of the grant of the patent:
**23.09.2020 Bulletin 2020/39**

(51) Int Cl.:
*G06F 7/544* *(2006.01)* *G06F 7/60* *(2006.01)*

(21) Application number: **17210864.9**

(22) Date of filing: **28.12.2017**

(54) **SYSTEM AND METHOD FOR TUNABLE PRECISION OF DOT-PRODUCT ENGINE**

SYSTEM UND VERFAHREN FÜR ABSTIMMBARE GENAUIGKEIT VON DOT-PRODUKT-MOTOR

SYSTÈME ET PROCÉDÉ DE PRÉCISION RÉGLABLE DE MOTEUR DE PRODUIT SCALAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.07.2019 Bulletin 2019/27**

(73) Proprietors:
• **IMEC vzw**
**3001 Leuven (BE)**
• **Katholieke Universiteit Leuven**
**3000 Leuven (BE)**

(72) Inventors:
• **GUPTA, Mohit**
**3001 Leuven (BE)**
• **DEHAENE, Wim**
**3001 Leuven (BE)**
• **SAKHARE, Sushil**
**3001 Leuven (BE)**
• **WECKX, Pieter**
**3001 Leuven (BE)**

(74) Representative: **DenK iP**
**Hundelgemsesteenweg 1116**
**9820 Merelbeke (BE)**

(56) References cited:
**US-A- 5 391 938**

• **SAYEH SHARIFY ET AL: "Loom: Exploiting
Weight and Activation Precisions to Accelerate
Convolutional Neural Networks", ARXIV.ORG,
CORNELL UNIVERSITY LIBRARY, 201 OLIN
LIBRARY CORNELL UNIVERSITY ITHACA, NY
14853, 23 June 2017 (2017-06-23), XP080772223,**
• **Renzo Andri ET AL: "YodaNN: An Architecture
for Ultra-Low Power Binary-Weight CNN
Acceleration", , 17 June 2016 (2016-06-17),
XP055485030, Retrieved from the Internet:
URL:https://arxiv.org/pdf/1606.05487.pdf**
• **Matthieu Courbariaux ET AL: "Binarized Neural
Networks: Training Deep Neural Networks with
Weights and Activations Constrained to +1 or -1",
arXiv.org - arXiv.org, 17 March 2016 (2016-03-17),
XP055405835, Retrieved from the Internet:
URL:https://arxiv.org/pdf/1602.02830.pdf**

## Description

## Field of the invention

The present invention relates to the field of integrated machine learning neuromorphic computing and neural networks, more particularly to hardware implementation of multi-layer perceptrons. In particular, the present invention relates to a semiconductor cell for performing dot-product operations between a first and a second operand, an array of such cells, and to a neural network comprising such array.

## Background of the invention

Neural networks (NNs) are classification techniques used in the machine learning domain. Typical examples of such classifiers include Multi-Layer Perceptrons (MLPs) or Convolutional Neural Network (CNNs).
Neural network (NN) architectures comprise layers of "neurons" (which are basically multiply-accumulate units), weights that interconnect them and particular layers, used for various operations, among which normalization or pooling. As such, the algorithmic foundations for these machine learning objects have been established at length in prior art.
The computation involved in training or running these classifiers has been facilitated using Graphics Processing Units (GPUs) or custom Application-Specific Integrated Circuits (ASICs), for which dedicated software flows have been extensively developed.
Many software approaches have advocated the use of NNs (either MLPs or CNNs) with binary weights and activations, showing minimal accuracy degradation of state-of-the-art classification benchmarks. The goal of such approaches is to enable neural network GPU kernels of smaller memory footprint and higher performance, given that the data structures exchanged from/to the GPU are aggressively reduced. However, none of the known approaches can overcome the high energy that is involved for each classification run on a GPU, especially the leakage energy component related solely to the storage of the NN weights. A benefit of assuming weights and activations of two possible values each (either +1 or -1) is that the multiply-accumulate operation (i.e. dot-product) that is typically encountered in NNs boils down to a popcount of element-wise XNOR or XOR operations.
A dot-product or scalar product is an algebraic operation that takes two equal-length sequences of numbers and returns a single number. A dot-product is very frequently used as a basic mathematical NN operation. At least at the inference phase (i.e. not during training), a wide range of machine learning implementations (e.g. MLPs or CNNs) can be decomposed to layers of dot-product operators, interleaved with simple arithmetic operations. Most of these implementations pertain to the classification of raw data (e.g. the assignment of a label to a raw data frame).

Dot-product operations are typically performed between values that depend on the NN input (e.g. a frame to be classified) and constant operands. The input-dependent operands are sometimes referred to as "activations". For the case of MLPs, the constant operands are the weights that interconnect two MLP layers. For the case of CNNs, the constant operands are the filters that are convolved with the input activations or the weights of the final fully connected layer. A similar thing can be said for the simple arithmetic operations that are interleaved with the dot-products in the classifier: for example, normalization is a mathematical operation between the outputs of a hidden layer and constant terms that are fixed after training of the classifier.
Dot-product operations, and therefore also neuromorphic applications, are read dominated. In terms of energy, this means that read energy outweighs write energy. Reduction in read energy is becoming an inevitable concern to do deep neural networks like BNN (binary neural network).
US 5391938 (Hatsuda, T.), February 21, 1995, discloses a high speed comparator with sensing and comparing functionality in small hardware, especially in the context of high speed comparisons carried out in translation look-ahead buffers and microprocessor cache memory tagging. The comparator is comparing voltage signals of an address pair with voltage signals of a bit pair, the voltage signals of the address pair and of the bit pair being received as complements. Coincidence and non-coincidence of the bit and the address voltage signal under comparison are detected as a current flowing and no current flowing through at least one current path extending through a load resistance and one of a pair of bipolar transistors forming a differential amplifier. The differential amplifier is connected to or forms part of an exclusive OR/exclusive NOR gate.

## Summary of the invention

It is an object of the present invention to reduce energy requirements of classification operations.
The above objective is accomplished by a semiconductor cell, an array of semiconductor cells and a method of using at least one array of semiconductor cells in a neural network, according to embodiments of the present invention.
In a first aspect, a semiconductor cell is provided, which is suitable for performing computing in an array comprising a plurality of such semiconductor cells. The semiconductor cell is comprising a memory element for storing a first binary operand, which memory element provides complementary memory outputs, and a multiplication block that is locally and uniquely associated with the memory element. The multiplication block is configured for receiving complementary input signals representing binary input data and the complementary memory outputs of the associated memory element representing the first binary operand, and for implementing a multiplication operation on these signals, and for providing an output of the multiplication operation to an output port. The output port is operatively connectable to a read bit line of the array such that the output of the multiplication operation is coupled from the output port to the read bit line.

In a semiconductor cell according to embodiments of the present invention, the multiplication block may be adapted to perform an XNOR or XOR logic function between the input data and the stored first binary operand.

A semiconductor cell according to embodiments of the present invention may furthermore comprise a select switch for controlling provision of the output of the multiplication operation to an external circuit.

In a semiconductor cell according to embodiments of the present invention, the memory element may be implemented in an SRAM implementation. In such embodiments, a binary weight may be stored as the first operand in cross-coupled invertors of the SRAM implementation.

In a semiconductor cell according embodiments of the present invention, the memory element may furthermore comprise at least one input for receiving the first binary operand from a data line and at least one access switch connecting the at least one input to a memory unit of the memory cell, the at least one access switch being adapted for being driven by a word line for passing the first binary operand to the memory unit. Such semiconductor cell may have two access switches connecting two inputs to a memory unit, for providing complementary data of the first binary operand to the memory unit.

In a second aspect, the present invention provides an array of semiconductor cells according to any of the embodiments of the first aspect, logically arranged in rows and columns.

An array according to embodiments of the second aspect may furthermore comprise word lines along the rows of the array and bit lines along the columns thereof, whereby the crossing of a set of word lines and bit lines uniquely identifies a location of a semiconductor cell in the array

An array according to embodiments of the present invention may comprise word lines configured for delivering complementary input activations to input ports of the semiconductor cells, and read bit lines configured for receiving the outputs of the multiplication operations from the readout ports of the semiconductor cells in the array connected to that read bit line.

In a third aspect, the present invention provides a neural network circuit comprising at least one array of semiconductor cells according to any of the embodiments of the second aspect; and a plurality of sensing units. A sensing unit is shared between different semiconductor cells of at least one column of the at least one array, for reading the outputs of the multiplication blocks of the shared semiconductor cells. The sharing of the sensing unit between different semiconductor cells of at least one column of the at least one array implements a time multiplexing operation. The neural network furthermore comprises a plurality of accumulation units, each accumulation unit arranged to sequentially accumulate the outputs of a particular sensing unit corresponding to sequentially selected semiconductor cells of the shared semiconductor cells.

A neural network circuit according to embodiments of the present invention may furthermore comprise a plurality of post-processing units for further processing of the output signals of the accumulation units.

In a neural network circuit according to embodiments of the present invention, at least two semiconductor cells that are sharing a single sensing unit may be grouped into an enlarged semiconductor unit, whereby the output ports of the at least two semiconductor cells are connected to a switch element, the output of the switch element being connected to the single sensing unit. The switch element may, in some embodiments, be adapted for allowing two multiplications and a single accumulation.

In such a neural network circuit, the switch element may be adapted for allowing multi-bit accumulation of the multiplication result of the at least two semiconductor cells grouped into the enlarged semiconductor unit. The accumulation may in some embodiments be achieved by using a high-impedance pre-charged SU, and then taking the outputs of the SU at a specific time. In particular embodiments, two semiconductor cells may be grouped into the enlarged semiconductor unit, and the switch element may be adapted for allowing two-bit accumulation for simultaneous readout of the two semiconductor cells grouped into the enlarged semiconductor unit. The switch element may comprise a first transistor with a first control electrode and a first and second main electrode and a second transistor with a second control electrode and a third and fourth main electrode. In the particular implementation where the transistors are MOS transistors, a control electrode may be a gate of a transistor and a main electrode may be source or a drain of a transistor. The first and third main electrodes are coupled together to a first reference voltage, and the second and fourth main electrodes are coupled together, potentially through a multiplexing switch, to the sensing unit. The first reference voltage should be a low-impedance voltage source. It can be ground for an NMOS implementation of the transistors, or supply voltage for a PMOS implementation. However, the present invention is not limited thereto, and the first reference voltage could be other voltages as well that suit the SU operation to distinguish the states that need be detected.

In the neural network circuit, an output signal of a first semiconductor cell of the at least two grouped semiconductor cells is coupled to the first control electrode, and an output of a second semiconductor cell of the at least two grouped semiconductor cells is coupled to the second control electrode. In particular embodiments, the switch element may furthermore comprise a third transistor with a third control electrode and a fifth and sixth main electrode and a fourth transistor with a fourth control electrode and a seventh and eighth main electrode coupled in series whereby the sixth main electrode is connected to the seventh main electrode, the fifth main electrode is coupled with the first and third main electrodes, and the eighth main electrode is coupled with the second and fourth main electrodes, the output of the first semiconductor cell being coupled to the third control electrode, and the output of the second semiconductor cell being coupled to the fourth control electrode.

In embodiments of the present invention, two activations are read simultaneously and are sensed as one cell. This reduces the read energy consumption by roughly half.

In a further aspect, the present invention provides the use of a neural network according to embodiments of the third aspect of the present invention for performing a clustering, classification or pattern recognition task. The neural network receives inputs from the external world in the form of a pattern and image in vector form. Each input is multiplied by its corresponding weight in a semiconductor cell according to embodiments of the present invention. Weights are the information used by the neural network to solve a problem. Typically weights represent the strength of the interconnection between neurons inside the neural network. The weighted inputs are sensed and accumulated, and potentially limited to fall within a desired range (normalized). The neural network may be used for prediction, e.g. for processing or predicting the transition of a first frame to a second frame, based on a sequence of input frames that have been fed to the system.

It is an advantage of embodiments of the present invention that a hardware based solution is provided to reduce energy consumption. Furthermore, the same hardware based solution reduces read delay.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

**Brief description of the drawings**

The invention will now be described further, by way of example, with reference to the accompanying drawings, in which:

FIG. 1 is a high-level illustration of a neural network;
FIG. 2 is a bloc-schematic illustration of a semiconductor cell according to embodiments of a first aspect of the present invention;
FIG. 3 schematically illustrates a neural network according to embodiments of the present invention;
FIG. 4 schematically illustrates a semiconductor cell according to embodiments of the present invention, located at a cross point of a set of word lines and a set of bit lines;
FIG. 5 illustrates in more detail the semiconductor cell of FIG. 4;
FIG. 6 illustrates an SRAM implementation of a semiconductor cell with a select switch according to one embodiment of the present invention;
FIG. 7 schematically illustrates a semiconductor cell according to embodiments of the present invention, like the embodiment of FIG. 4 but with one word line less;
FIG. 8 illustrates in more detail the semiconductor cell of FIG. 7;
FIG. 9 illustrates an SRAM implementation of a semiconductor cell without select switch according to another embodiment of the present invention;
FIG. 10 schematically illustrates a neural network according to another embodiment of the present invention;
FIG. 11 schematically illustrates a neural network according to yet another embodiment of the present invention, with enlarged semiconductor units;
FIG. 12 illustrates one column in an array of cells in the implementation of a neural network as in FIG. 11;
FIG. 13 schematically illustrates an enlarged semiconductor unit as can be used in a column as illustrated in FIG. 12, with the word lines and bit lines to which it is connected;
FIG. 14 illustrates in more detail an SRAM implementation of an enlarged semiconductor unit as used in the implementation of FIG. 11, with one type of select switch;
FIG. 15 illustrates in more detail an SRAM implementation of an enlarged semiconductor unit as used in the implementation of FIG. 11, with another type of select switch;
FIG. 16 illustrates a neural network with semiconductor units as in FIG. 14;
FIG. 17 shows Monte Carlo simulation results of a neural network implemented in accordance with FIG. 14;
FIG. 18 illustrates an alternative to the embodiment illustrated in FIG. 14, which allows to better discriminate between different situations, in NMOS implementation;
FIG. 19 illustrates an alternative to the embodiment of FIG. 18, in PMOS implementation;
FIG. 20 shows Monte Carlo simulation results of a neural network implemented in accordance with FIG. 18; and
FIG. 21 illustrates a sensing unit design for use with embodiments of the present invention.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, directional terminology such as top, bottom, front, back, leading, trailing, under, over and the like in the description and the claims is used for descriptive purposes with reference to the orientation of the drawings being described, and not necessarily for describing relative positions. Because components of embodiments of the present invention can be positioned in a number of different orientations, the directional terminology is used for purposes of illustration only, and is in no way intended to be limiting, unless otherwise indicated. It is, hence, to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being re-defined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

In embodiments of the present invention, semiconductor cells are logically organized in rows and columns. Throughout this description, the terms "horizontal" and "vertical" (related to the terms "row" and "column", respectively) are used to provide a co-ordinate system and for ease of explanation only. They do not need to, but may, refer to an actual physical direction of the device. Furthermore, the terms "column" and "row" are used to describe sets of array elements, in particular in the present invention semiconductor cells, which are linked together. The linking can be in the form of a Cartesian array of rows and columns; however, the present invention is not limited thereto. As will be understood by those skilled in the art, columns and rows can be easily interchanged and it is intended in this disclosure that these terms be interchangeable. Also, non-Cartesian arrays may be constructed and are included within the scope of the invention. Accordingly, the terms "row" and "column" should be interpreted widely. To facilitate in this wide interpretation, the claims refer to logically organized in rows and columns. By this is meant that sets of semiconductor cells are linked together in a topologically linear intersecting manner; however, that the physical or topographical arrangement need not be so. For example, the rows may be circles and the columns radii of these circles and the circles and radii are described in this invention as "logically organized" rows and columns. Also, specific names of the various lines, e.g. word line and bit line, are intended to be generic names used to facilitate the explanation and to refer to a particular function and this specific choice of words is not intended to in any way limit the invention. It should be understood that all these terms are used only to facilitate a better understanding of the specific structure being described, and are in no way intended to limit the invention.

For the technical description of embodiments of the present invention, the design enablement of a multi-layer perceptron (MLP) with binary weights and activations is focused on. A similar description is valid, but not written out in detail, for convolutional neural networks (CNNs), with the appropriate reordering of logic units and the designation of the memory unit as storing binary filter values, instead of binary weight values.

Artificial neural networks are computing systems inspired by the biological neural networks that constitute human and animal brains. Such systems learn to do tasks by considering examples, generally without task-specific programming.

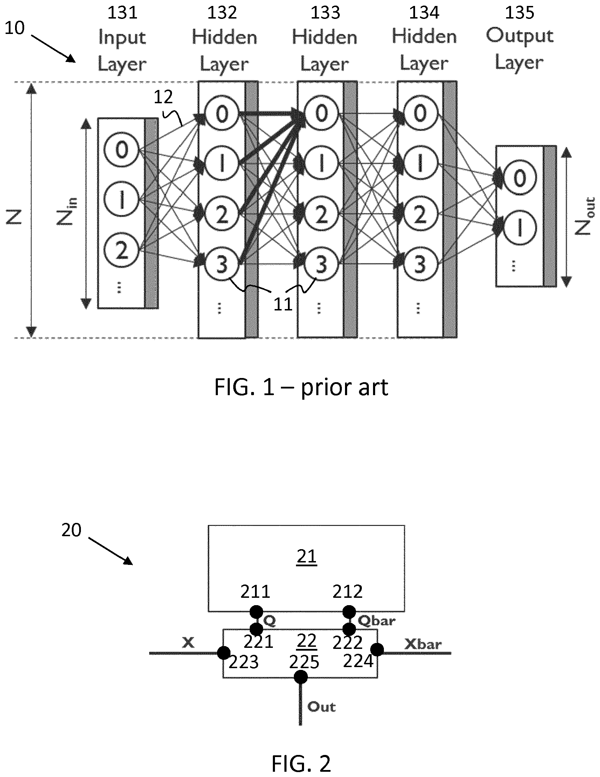

FIG. 1 is a schematic illustration of an artificial neural network 10. Such artificial neural network 10 is based on a collection of connected units called artificial neurons 11. In FIG. 1, each circular node represents an artificial neuron 11, and an arrow represents a connection (synapse) 12 from the output of one neuron 11 to the input of another one. Each synapse 12 between neurons 11 can transmit a signal from one neuron 11 to another neuron 11. The receiving neuron 11 can process the received signal and then transmit the processed signal to downstream neurons 11 connected to it.

Typically, neurons 11 are organized in layers. Neurons 11 of different layers may perform different kinds of transformations on their inputs. In FIG. 1, a number L of five layers 131, 132, 133, 134, 135 is illustrated. Signals travel from the first layer (input layer) 131 to the last layer (output layer) 135, possibly after traversing a plurality of intermediate layers, in the embodiment illustrated after traversing three intermediate layers 132, 133, 134.

The input layer 131 may have a first number $N_{in}$ of neurons 11, and may hence accept the first number $N_{in}$ of inputs. There may be a second number $N_i$ of neurons 11 per intermediate layer 132, 133, 134, with $N_i$ dependent on the intermediate layer and on the application. The output layer 135 may have a third number $N_{out}$ of neurons 11. For training, $N_{in}$, $N_i$ and $N_{out}$ can be any number. For testing or classification, $N_{out}$ should be smaller than $N_{in}$ ($N_{out} < N_{in}$). The neural network 10 is dimensioned in terms of N (maximum number of neurons in any of the layers) and L (number of layers).

Neurons may have a state, generally represented by a real number, typically between 0 and 1. In particular implementations, these states are weights that vary as learning proceeds, which can increase or decrease the strength of the signal that it sends downstream.

In the particular example of Binary Neural Networks (or Binary MLP), first operands under the form of weights w are stored in the neurons 11, and second operands under the form of input activations x are received by the neurons. They may both be confined in the [-1, +1] interval. During training, the weights w and the input activations x are scalar values (w, x $\in$ [-1, +1]). During testing, the weights w and the input activations x may be binary values (w, x $\in$ {-1, +1}).

As illustrated in FIG. 1, each layer comprises a calculation part (the white box) and it may furthermore comprise a normalization and non-linearity part (the grey box).

In the example of BNN, the calculation part processes incoming input activations x and locally stored weights w, so as to obtain $y_k = \sum_{j=0}^{N-1} x_j w_{kj}$, with k the neuron in the next layer. This operation is called a dot-product operation. Evaluation of the $k^{th}$ neuron in a subsequent layer would be the dot-product of 0 to N-1 inputs (x) with weights (w). Each neuron in a subsequent layer will have same inputs but weights will be different.

The normalization and non-linearity part may process the thus obtained output values $y_k$ of each neuron as follows, with $\mu$, $\sigma$, $\gamma$, $\beta$ normalization parameters obtained from training:

$$y' = \frac{y - \mu}{\sigma} \gamma + \beta$$

$$y'' = \mathbf{sign}\{y'\} = \begin{cases} +1 \ if \ y' \geq 0 \\ -1 \ if \ y' < 0 \end{cases}$$

If at test time the weight values w and the input activations x are binary values (w, x ∈ {-1, +1}), this corresponds in binary logic with w, x ∈ {0, 1}. As a result, the dot-product operation corresponds to the following truth table:

| w | | x | | Product | |
|---|---|---|---|---|---|
| -I | 0 | -I | 0 | +I | I |
| -I | 0 | +I | I | -I | 0 |
| +I | I | -I | 0 | -I | 0 |
| +I | I | +I | I | +I | I |

Hence the dot-product operation (product between weight w and input activation x) which is the core operation in such neural networks, is actually an XNOR operation. If one or the inputs is swapped in sign, this can be expressed as an XOR operation.

In a first aspect, the present invention relates to a semiconductor cell 20, as illustrated in FIG. 2, for performing a multiplication operation between a first and a second operand. The semiconductor cell 20 comprises a memory element 21 for storing the first operand. The memory element 21, in some embodiments, may have a single input port for receiving the first operand. The first operand may locally be converted into complementary data. In alternative embodiments, the memory element 21 may have two input ports for receiving complementary data representing the first operand. The memory element 21 has a first output port 211 and a second output port 212, each providing complementary memory outputs, respectively, e.g. Q and Qbar, respectively. The first operand is thus a constant value, which is stored in place in the semiconductor cell 20, more particularly in the memory element 21 thereof.

The semiconductor cell 20 furthermore comprises a multiplication block 22. The multiplication block 22 is locally and uniquely associated with the memory element 21 of the semiconductor cell 20. The multiplication block 22 has a first input port 221 and a second input port 222, for receiving the complementary memory outputs Q, and Qbar, from the first and second output ports 211, 212 of the memory element 21, respectively. The multiplication block 22 further has a third input port 223 and a fourth input port 224, for receiving the second operand X and its complement Xbar, respectively. The second operand X is a value fed to the semiconductor cell 20, which may be variable, and which may depend on the current input to the semiconductor cell 20, for instance a frame to be classified. The second operands X are sometimes referred to as "activations" or "input activation". In particular embodiments of the present invention, where MLPs are involved, the first operand can be one of the weights that interconnect two MLP layers. In alternative embodiments, where CNNs are involved, the first operand can be one of the filters that are convolved with the input activations, or a weight of a final fully connected layer.

The multiplication block 22 is configured for implementing a multiplication operation between the first operand stored in its associated memory element 21 and the second operand received by the semiconductor cell 20. The multiplication is done in place, i.e. within the semiconductor cell 20. The multiplication block 22 has an output port 225 for outputting the result Out of the multiplication operation, e.g. a digital output, for instance for putting this result on a column line.

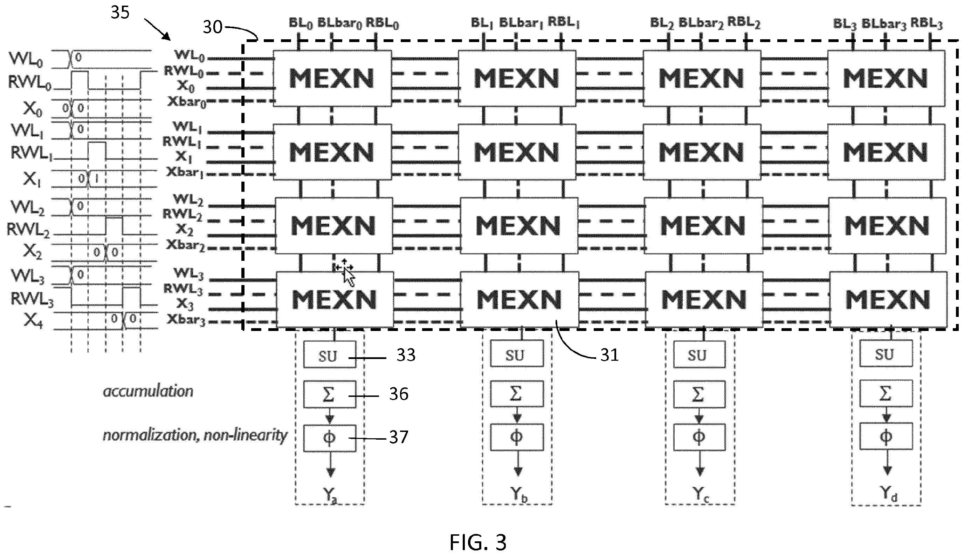

In a second aspect, a plurality of such semiconductor cells 20 may be arranged in an array 30, whereby the semiconductor cells are logically arranged in rows and columns, as for instance illustrated in FIG. 3. The semiconductor cells may be semiconductor cells 20 as illustrated in FIG. 2, but the embodiment illustrated in FIG. 3 includes a slightly modified version of semiconductor cells, indicated as semiconductor cells 31. These semiconductor cells 31 not only include the memory element 21 and the multiplication block 22, but furthermore also include a select switch 32 for coupling the output of the semiconductor cell to a read bit line. In alternative embodiments where semiconductor cells 20 as illustrated in FIG. 2 are arranged in an array 30, a select switch can be provided outside the semiconductor cell 20 for coupling the semiconductor cell 20 to a read bit line.

In FIG. 3, for simplicity and readability of the figure, the separate blocks (memory element 21, multiplication block 22, select switch 32) of a semiconductor cell 31 according to embodiments of the first aspect of the present invention are not illustrated, but all elements of the array 30 are semiconductor cells 31 of the type according to embodiments of the first aspect of the present invention. These semiconductor cells 31 are indicated MEXN in the drawing, meaning that a local combination of a memory element 21 and a multiplication block 22 is made, in accordance with embodiments of the first aspect of the present invention, and that furthermore a select switch 32 is provided inside the semiconductor cell 31.

Such array 30 may comprise word lines configured for delivering second operands (input activations x) to input ports of the semiconductor cells 31. The input ports of the semiconductor cells 31 may coincide with or be linked to the third and fourth input ports 223, 224 of the multiplication block. The array 30 may also comprise read bit lines configured for receiving the outputs of the multiplication operation from readout ports of the semiconductor cells 31 connected to that read bit line. The readout port of a semiconductor cell 31 may coincide with or be linked to the output port 225 of the multiplication block 22.

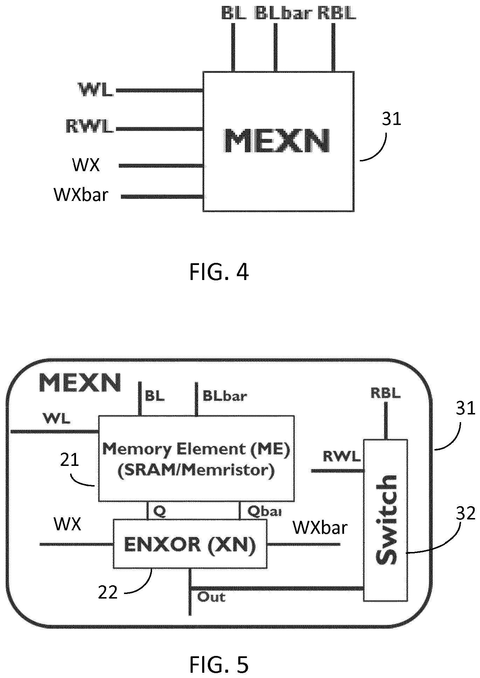

FIG. 4 and FIG. 5 illustrate the word and bit lines connected to a particular embodiment of a semiconductor cell 31 according to embodiments of the first aspect of the present invention when organized in an array 30. As illustrated in FIG. 5, the semiconductor cell 31, comprising the memory element 21 and the multiplication block 21, furthermore comprises a select switch 32 for coupling the output of the semiconductor cell to a read bit line.

It can be seen from FIG. 4 that, for this embodiment, four horizontal word lines are connected to each semiconductor cell 31 in the array 30, as well as three bit lines. The four word lines are

- a first word line WL for activating an access switch 38 for passing a first operand to a memory unit 34 of the memory element 21 for being stored there; the first operand is stored when the access switch 38 is actuated; once the access switch 38 is turned off, the stored operand remains in the memory element 21,
- second and third word lines WX and WXbar, respectively, for applying incoming input activations X and Xbar to the multiplication block 22, and
- a read word line RWL for activating a select switch 32 for bringing the output of the semiconductor cell 20 to a readout bus (read bit line RBL as indicated below).

The three vertical bit lines, for this embodiment, are

- a first bit line BL for applying a first operand to an access switch for being passed to the memory unit of the memory element 21 for being stored there. In the particular embodiment illustrated in the drawings, the memory unit is a cross coupled invertor invertor configuration storing complementary versions of the first operand. The first operand may be applied via the first bit line, and a complementary version thereof may be generated inside the semiconductor cell (not illustrated), in which case a single first bit line BL is sufficient. However, in alternative embodiments, the complementary versions of the first operand may be generated outside the semiconductor cell 20, in which case both the first operand and its complement are to be brought to the memory unit, which requires the first bit line BL and a second bit line BLbar, for applying the complementary pair to the memory unit.
- a third bit line RBL for accepting an output value of the semiconductor cell, upon activation of the select switch 32 by a corresponding signal on the read word line RWL.

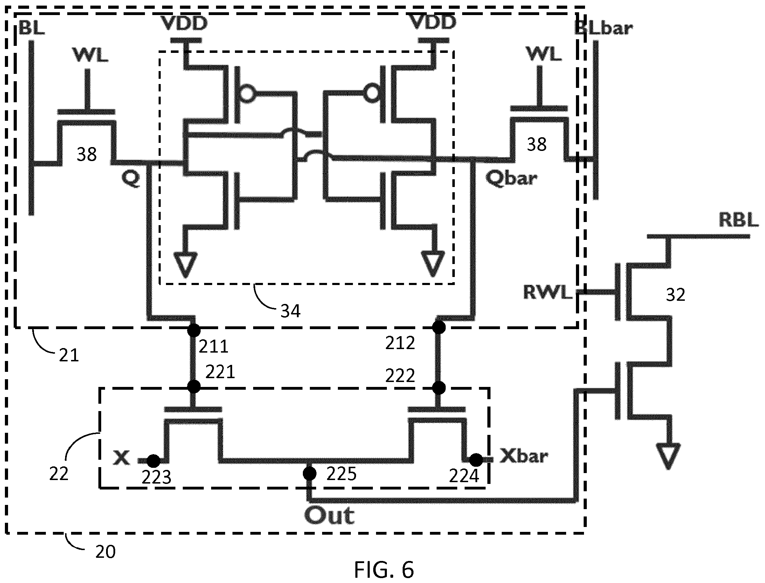

FIG. 6 illustrates a particular semiconductor cell 20, with the word lines and bit lines as described with reference to FIG. 4 and FIG. 5.

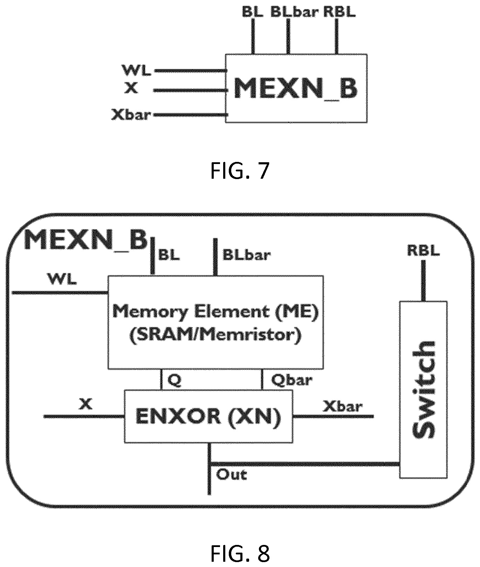

FIG. 3 illustrates a neural network circuit an array 30 according to embodiments of a third aspect of the present invention. In the embodiment illustrated, each read bit line RBL connecting semiconductor cell 31 logically arranged on a column of the array 30 is connected to a sensing unit 33, for instance a sense amplifier. A sensing unit 30 is thus shared between different semiconductor cells 31 of the array 30, for reading the outputs of the multiplication blocks 22 of these semiconductor cells 31. In particular embodiments, such as for instance the embodiment illustrated in FIG. 3 and in FIG. 7, one sensing unit 33 is provided for every column of semiconductor cells 31 in the array 30. By doing so, all columns may be simultaneously sensed. The sensing unit 33 senses the values put on the read bit line RBL sequentially by each of the semiconductor cells 31 logically arranged on the column associated with that read bit line RBL. The sharing of the sensing unit 33 by the plurality of semiconductor cells is thus a time sharing. The sequence of putting the values on the read bit line RBL is determined by the signals on the fourth word lines RWL, which activate the select switches 32 of the different rows, such that each semiconductor cell 31 delivers its value in sequence. In alternative embodiments, not illustrated in the drawings, a sensing unit may be shared between semiconductor cells of more than one column of the array.

The read out values are then accumulated in accumulators 36. If so required, the accumulated values may be further processed in post-processing units 37. The further processing may comprise or consist of normalization and/or non-linear operations. The values so obtained per column can be read out and stored for further use, or can be directly used by further circuitry (not illustrated, and not discussed in further detail).

In the embodiment illustrated in FIG. 3, the rows of semiconductor cells 31 are accessed in sequence, for instance by a "walking one" (see the $RWL_i$ signal at the left-hand side of FIG. 3).

The activation signals $X_i$ ($X_i$ and $Xbar_i$) are directly fed into the semiconductor cells 31, more particularly they are put on the word lines WX and WXbar providing input to the multiplication block 22.

In this embodiment, and for the example illustrated, four cycles are needed to read out all multiplication values between the first and the second operands, i.e. one cycle for reading out each row. The read out values are then accumulated per column in accumulators 36, and, if so required, further processed in post-processing units 37. The further processing may comprise or consist of normalization and/or non-linear operations.

FIG. 7, FIG. 8 and FIG. 9 illustrate an alternative embodiment of what is described in FIG. 4, FIG. 5 and FIG. 6. The difference between both embodiments is that in the second embodiment the select transistor 32 can be left out. This implementation not only reduces one transistor per semiconductor cell, but also removes the need of presence of the read word line RWL. This can be obtained by activating the word lines WX and WXbar only when it is desired to sense the output values.

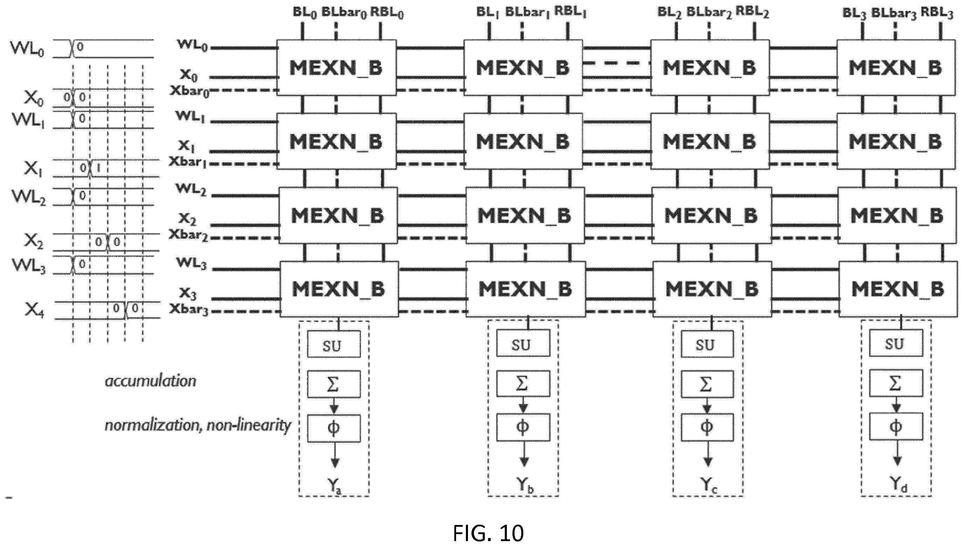

A corresponding timing diagram is shown at the left-hand side of FIG. 10, which else includes elements as in FIG. 3, except for the select transistor and its corresponding driving word line RWL.

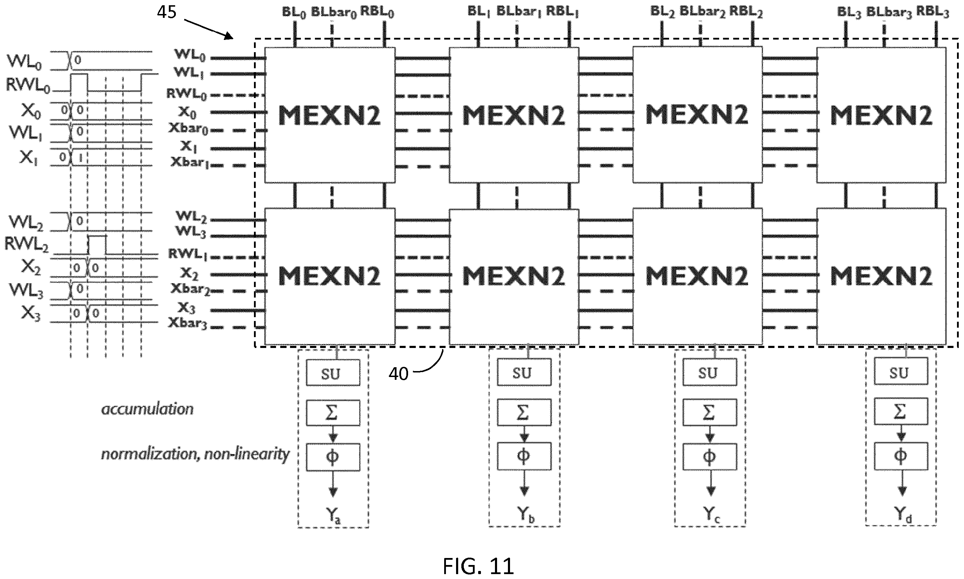

In an alternative embodiment of the third aspect, two activation inputs $X_i$ are enabled simultaneously, as illustrated in FIG. 11 (see signals at the left-hand side). The sensing of the two outputs after the multiplication operation, e.g. XNOR or XOR operation, may be done under single sensing. This procedure has the advantage that it reduces energy consumption by half, as only half of the read operations are needed. Moreover, also the reading delay is reduced.

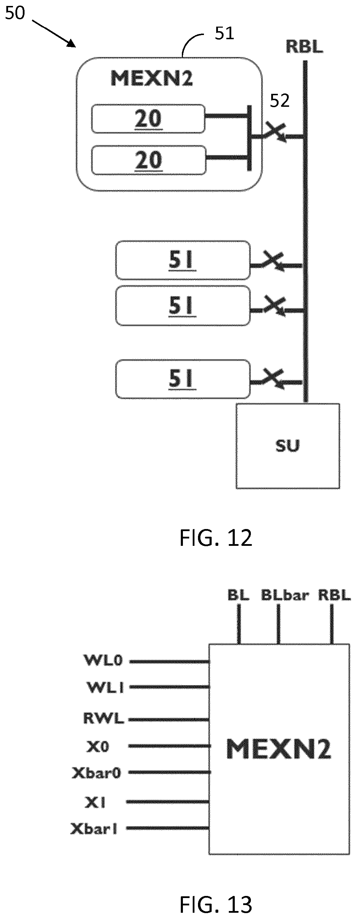

One column 50 of an array 40 according this embodiment is illustrated in FIG. 12. Two semiconductor cells 20, are combined into an enlarged semiconductor unit 51, indicated MEXN2, for simultaneous readout. Hereto, a switch element 52 is provided between the outputs of the semiconductor cells 20 and the read bitline RBL.

The connection to word lines and bit lines is illustrated in FIG. 13. It can be seen that, in this case, seven word lines connect to a single enlarged semiconductor unit 51, and three bit lines. The bit lines are as described with respect to FIG. 4. The word lines correspond to twice the bit lines as described with respect to FIG. 4 (one set to each semiconductor cell forming part of the enlarged semiconductor unit 51), minus 1 read word line because both semiconductor cells forming part of the enlarged semiconductor unit 51 are actuated simultaneously, hence via a single word line.

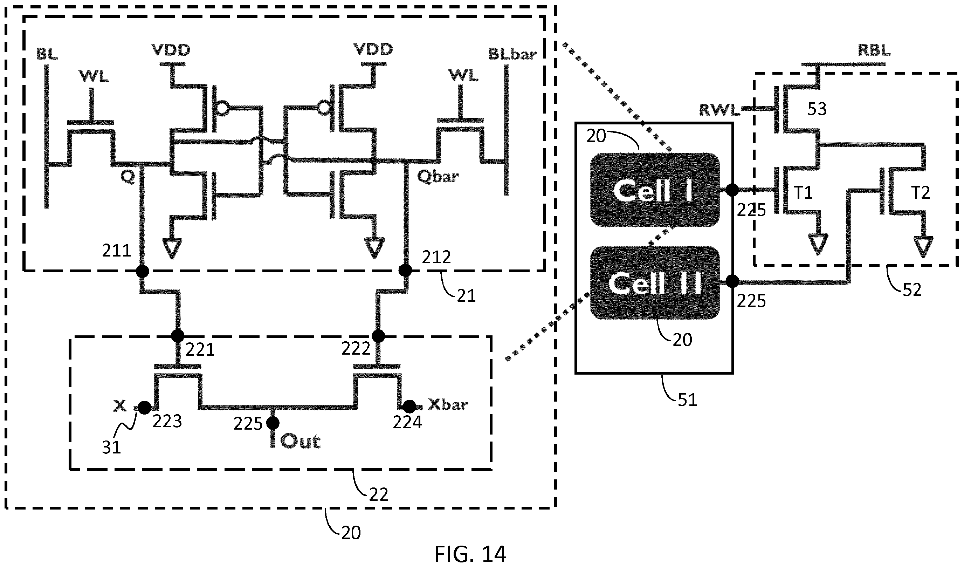

A detailed implementation example of semiconductor cells 20 and supplementary circuitry for use in the modified neural network circuit 45, enabling two inputs simultaneously, is illustrated in FIG. 14. In this embodiment, the memory element is implemented in SRAM technology.

Illustrated are two semiconductor cells 20 according to embodiments of the first aspect of the present invention. They are combined together in an enlarged semiconductor unit 51. One semiconductor cell 20, implemented in SRAM technology, is illustrated in more detail at the left-hand side of FIG. 14. It comprises an SRAM memory element 21, and a multiplication block 22. The multiplication block 22 is an XNOR or an XOR block (depending on the input activation signals).

The word line WL and the bit lines BL, BLbar are provided for writing a value into the memory element 21. The memory element 21 has a first output port 211 and a second output port 212 for delivering the stored value and its complementary value, respectively.

The multiplication block 22, in the embodiment illustrated the XNOR block, has an output port 225 for delivering the result of the multiplication operation carried out on the first operand, being the value stored in the memory element 21, and the second operand, being the input activation received by the semiconductor cell 20. The output ports 225 of the two semiconductor cells 20 together forming the enlarged semiconductor unit 51 are fed to a switch element 52.

The switch element 52 is such that the outputs 225 of the semiconductor cells 20 are each connected to a gate of a transistor T1, T2, the two transistors T1, T2 being coupled in parallel between ground and a read bitline RBL. A switch 53 is provided between the two transistors T1, T2 and the read bitline.

If the switch 53 is closed, e.g. if this switch is formed by a transistor, by bringing its gate, connected to a read word line RWL, to high, a combined output signal of the two semiconductor cells 20 can be read from the read bitline RBL. The read bitline is charged to high first (pre-charged). If the output of both semiconductor cells is low, the transistors T1 and T2 both do not go in conduction, and the charge brought on the read bitline RBL substantially remains there. When the sensing unit SU, e.g. sense amplifier, senses the charge on the read bitline RBL, it senses a high value, and it determines therefrom that the output of both semiconductor cells 20 being read out is low. If the output of either one of the semiconductor cells 20 is high, the read bitline RBL is pulled to ground, and the charges previously stored there leak away. If the output of both semiconductor cells 20 is high, the read bitline RBL is also pulled to ground and the previously stored charges leak away. This time, this goes even faster.

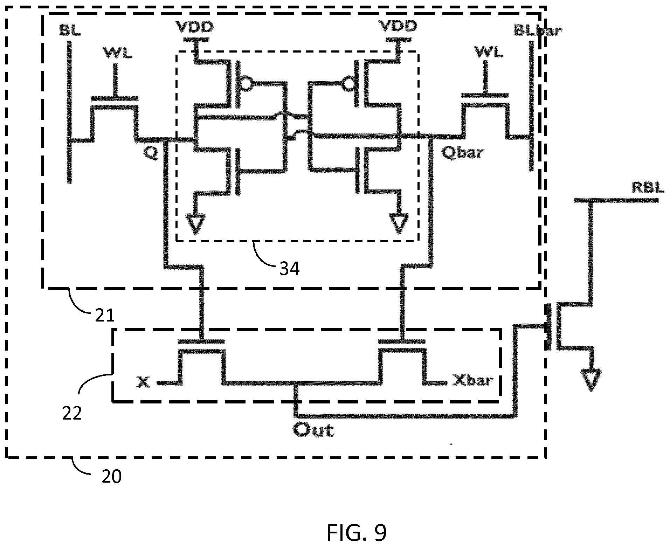

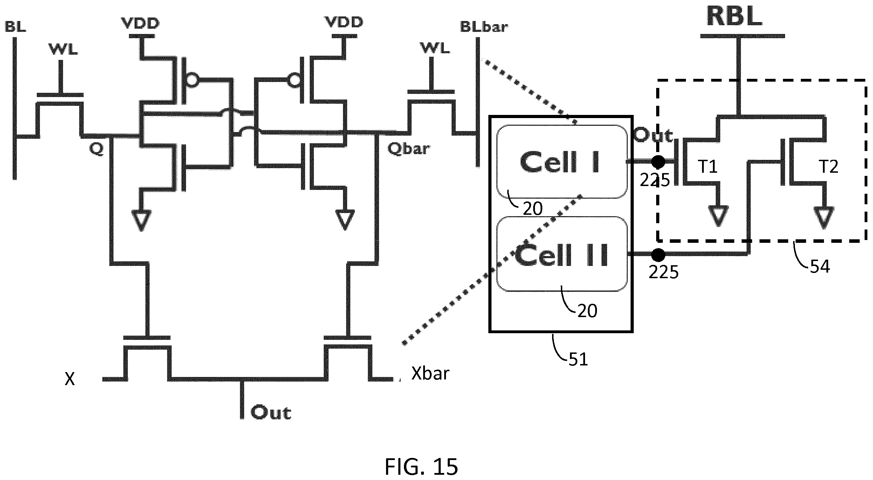

In an alternative embodiment to FIG. 14, as illustrated in FIG. 15, similarly to the embodiment illustrated in FIG. 9, the switch 53 can be left out. This way, a switch element 54 is provided, which only comprises the transistors T1 and T2. The outputs 225 of the semiconductor cells 20 are each connected to a gate of a transistor T1, T2, the main electrodes of the two transistors T1, T2 being coupled in parallel between ground and a read bitline RBL. This configuration can only be implemented provided the actuation of the word lines for applying incoming input activations to the multiplication block is accurately timed to happen only when it is desired to sense the value of the semiconductor cell. This implementation reduces one switch, e.g. transistor, per two semiconductor cells, and hence one signal line, and thus reduces energy consumption. However, it will increase leakage as well as capacitance on read bit line RBL.

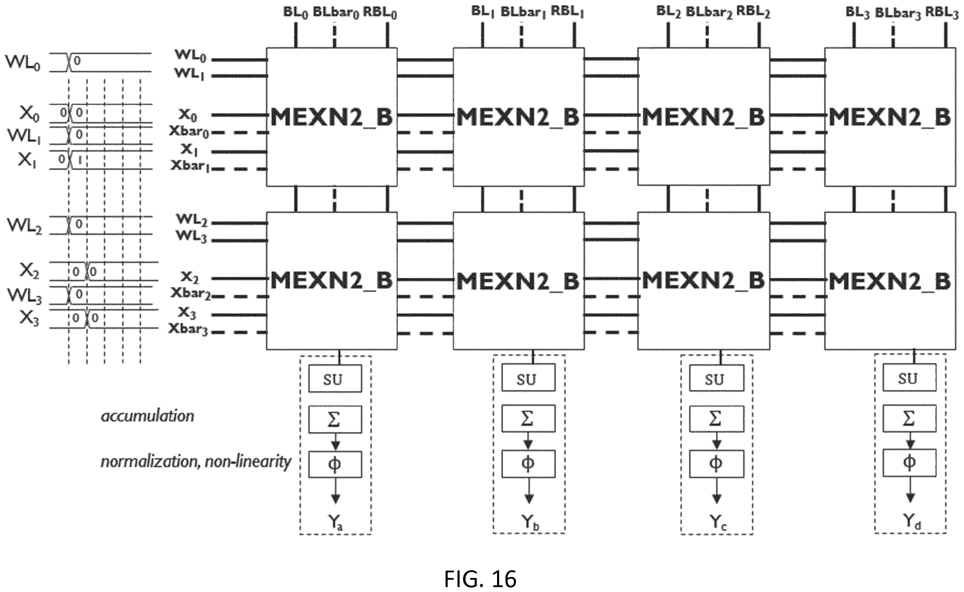

An array of enlarged semiconductor cells MEXN2_B, illustrated in detail in FIG. 15, is illustrated in FIG. 16. Explanation is similar to arrays described before, and a timing diagram can be found at the left-hand side of the drawing. Compared to FIG. 11 it can be seen that the word line for actuating the switch 53 has been omitted, as in this case this actuation is not required.

It is an advantage of these embodiments of the present invention with enlarged semiconductor units 51 that only one sense operation is required, where previously to read out the same, two sense operations and a separate combination operation would have been required. Simultaneous reading can now be done on a single bitline. This means lower read energy is required, and the readout throughput has doubled.

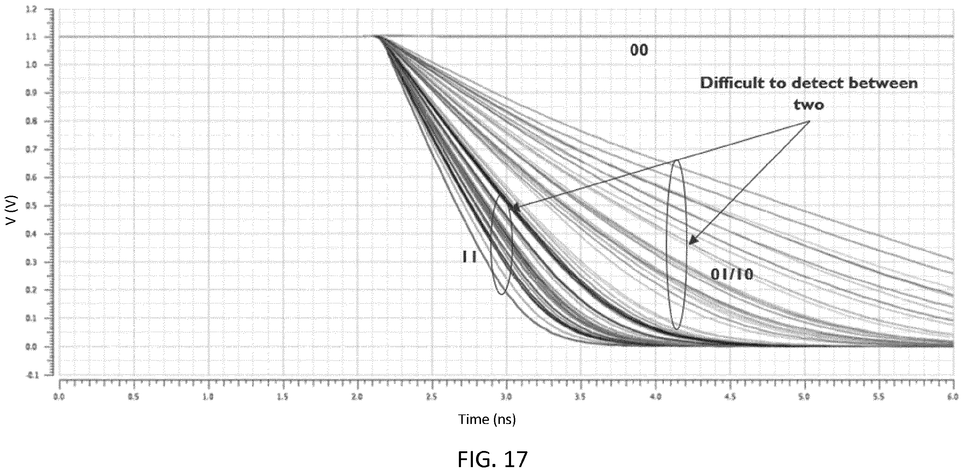

However, this process is illustrated in FIG. 17, which shows Monte Carlo Simulation results with 30 samples. It can be seen that it is hard to make the difference between both semiconductor cells 20 having an output high (11), and one having output high and the other one having output low (10 or 01).

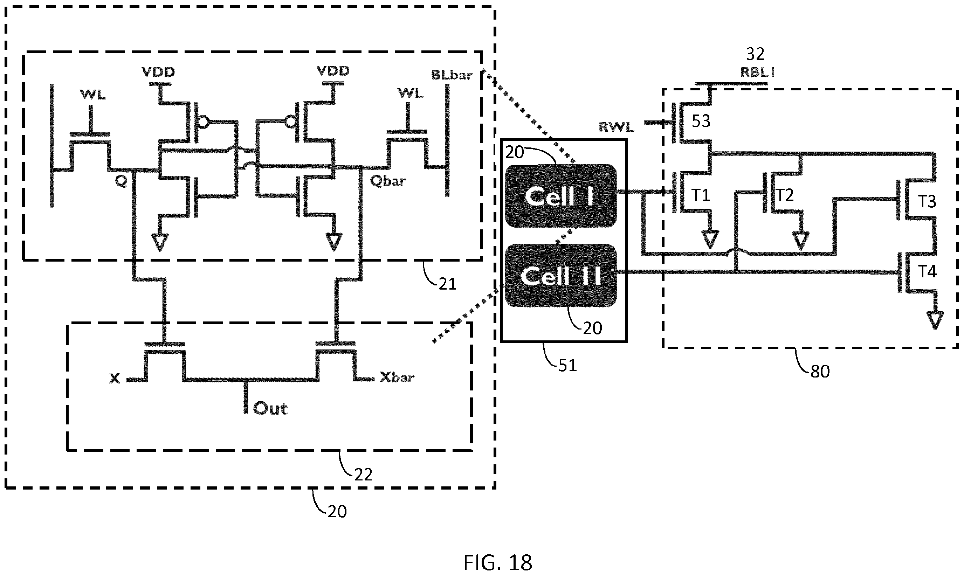

This can be solved by implementing the switch element differently, as for instance illustrated in FIG. 18. FIG. 18 corresponds to FIG. 14 as far as the enlarged semiconductor unit 51 is concerned. Only the switch element 80 between the enlarged semiconductor unit 51 and the read bitline RBL is different. In the embodiments illustrated, besides the connection between the outputs of the respective semiconductor cells 20 and the gates of the transistors T1 and T2 that are coupled in parallel (see also description of FIG. 14), the outputs of the semiconductor cells 20 are also coupled each to one of the gates of transistors T3 and T4, respectively, that are coupled in series, and this series coupling is coupled in parallel to the transistors T1 and T2 also coupled in parallel. Goal is to enhance the difference between resistance when only one of the transistors T1, T2 go into conduction, compared to when both go into conduction.

The way of working is similar, in that the read bitline RBL is charged high first, e.g. pre-charged at positive power supply voltage $V_{DD}$. If none of the semiconductor cells 20 have an output high, the charge remains on the read bitline RBL, and can be read out as such by the sensing unit SU, e.g. sense amplifier. If either one of the semiconductor cells 20 has an output high, one of the transistors T1 or T2, and only one of the transistors T3 or T4 go in conduction. The charge leaks away from the read bitline RBL and this charge drop can be detected by the sensing unit SU, e.g. sense amplifier. The charge does not leak away, however, over the series connection of transistors T3 and T4. If, however, both semiconductor cells 20 have an output high, all transistors T1, T2, T3 and T4 go in conduction, and charge leaks away from the read bitline RBL very fast. This fast or slower leaking away of the charge from the read bitline RBL can be detected by the sensing unit SU, e.g. sense amplifier, which can discriminate this way between the different situations.

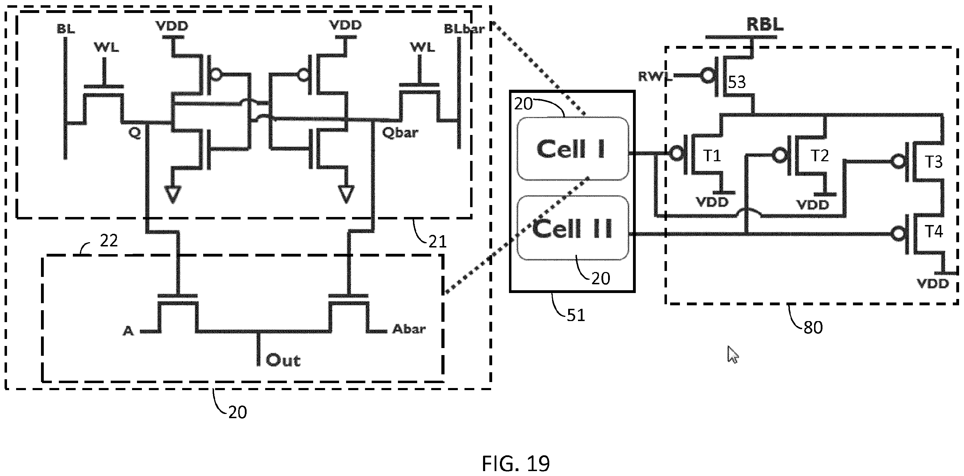

In the embodiment illustrated in FIG. 18, the switch 80 element is implemented in NMOS. Alternatively, this switch element 80 can also be implemented in PMOS, as illustrated in FIG. 19, which would only have implications as to the pre-charging of the read bit line RBL, but which would further be pretty much similar in operation. In this case, the read bit line RBL would be pre-discharged, for instance at ground level. If none of the semiconductor cells 20 have an output high, the charge on the read bitline RBL remains low, and can be read out as such by the sensing unit SU, e.g. sense amplifier. If either one of the semiconductor cells 20 has an output high, one of the transistors T1 or T2, and only one of the transistors T3 or T4 go in conduction. The read bit line RBL gets charged and this increase in charge on the read bit line RBL can be detected by the sensing unit SU. The read bit line RBL is not charged, however, over the series connection of transistors T3 and T4. If, however, both semiconductor cells 20 have an output high, all transistors T1, T2, T3 and T4 go in conduction, and the read bit line RBL is charged very fast. This fast or slower charging away of the read bitline RBL can be detected by the sensing unit SU, which can discriminate this way between the different situations.

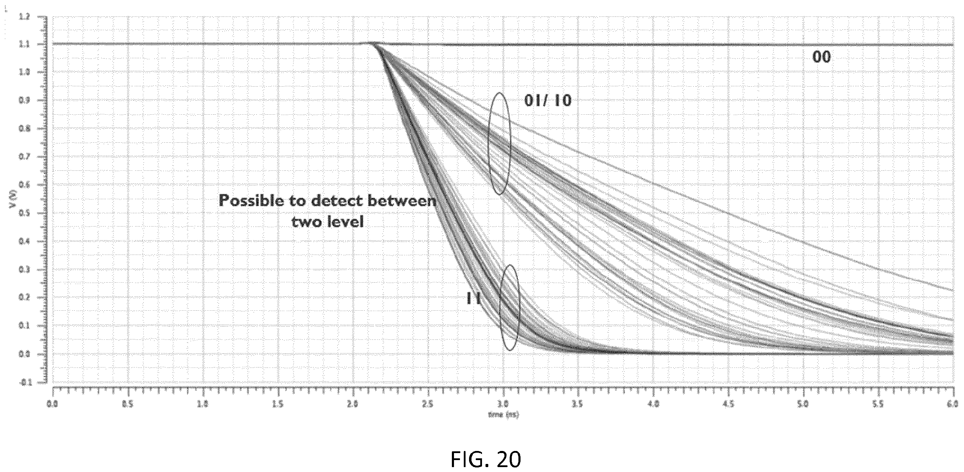

This is illustrated in the simulation results shown in FIG. 20.

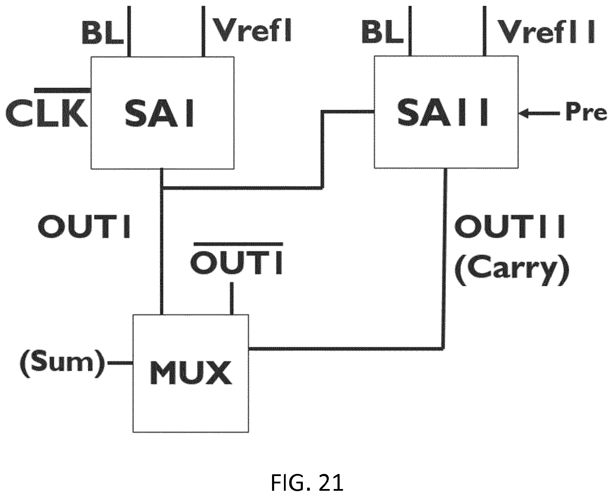

The sense amplifier design is as illustrated in FIG. 21. The first sense amplifier SA I corresponds to the typical implementation of memory. However, if it is desired to sense three levels, it is impossible to do this with only one sense amplifier with one reference VrefI. Therefore, a second sense amplifier SA II is used for sensing the third level, based on a second reference VrefII. The first sense amplifier SA I may for instance discriminate between 00 and anything else. The second sense amplifier SA II may then for instance discriminate between 01 or 10 and 11. The second sense amplifier SA II is only used when precision is needed. The output of the first sense amplifier SA I enables the second sense amplifier SA II.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments. For example, the invention does not need to be implemented with SRAM memory elements, but can make use of any type of non-volatile memory.

**Claims**

1. A semiconductor cell for computing in an array (30) comprising a plurality of semiconductor cells, the semiconductor cell (20, 31) comprising
a memory element (21) for storing a first binary operand, which memory element (21) provides complementary memory outputs (Q, Qbar), and
a multiplication block (22) that is locally and uniquely associated with the memory element (21), the multiplication block (22) being configured for receiving complementary input signals (X, Xbar) representing binary input data and the complementary memory outputs (Q, Qbar) of the associated memory element (21) representing the first binary operand, and for implementing a multiplication operation on these signals, and providing an output of the multiplication operation to an output port (225), the output port being operatively connectable to a read bit line (RBL) of the array for coupling the output of the multiplication operation from the output port to the read bit line.

2. The semiconductor cell (20, 31) according to claim 1, wherein the multiplication block (22) is adapted to perform an XNOR or XOR logic function between the input data (X, Xbar) and the stored first binary operand (Q, Qbar).

3. The semiconductor cell (31) according to any of the previous claims, furthermore comprising a select switch (32) for controlling provision of the output of the multiplication operation to an external circuit.

4. The semiconductor cell (20, 31) according to any of the previous claims, wherein the memory element (21) is implemented in an SRAM implementation.

5. The semiconductor cell (20, 31) according to any of the previous claims, wherein the memory element (21) furthermore comprises at least one input for receiving the first binary operand from a data line (BL, BLbar) and at least one access switch (38) connecting the at least one input to a memory unit (34) of the memory cell (21), the at least one access switch (38) being adapted for being driven by a word line (WL) for passing the first binary operand to the memory unit (34).

6. The semiconductor cell (20, 31) according to claim 5, having two access switches (38) connecting two inputs to a memory unit (34), for providing complementary data of the first binary operand to the memory unit (34).

7. An array (30) of semiconductor cells (20, 31) according to any of the previous claims, logically arranged in rows and columns, and comprising word lines along the rows of the array and bit lines along the columns thereof, the crossing of a set of word lines and bit lines uniquely identifying a location of a semiconductor cell (20, 31) in the array (30).

8. An array (30) according to claim 7, comprising word lines configured for delivering complementary input activations (X, Xbar) to input ports (223, 224) of the semiconductor cells (20), and comprising read bit lines (RBL) configured for receiving the outputs (Out) of the multiplication operations from the readout ports (225) of the semiconductor cells (20) in the array (30) connected to that read bit line (RBL).

9. A neural network circuit (35, 45) comprising at least one array (30) of semiconductor cells (20, 31) according to any of claims 7 to 8, and a plurality of sensing units (SU), each sensing unit (SU) being shared between different semiconductor cells (20, 31) of at least one column of the at least one array (30), for reading the outputs of the multiplication blocks (22) of the shared semiconductor cells (20, 31), and a plurality of accumulation units (36), each accumulation unit arranged to sequentially accumulate the outputs of a particular sensing unit (SU) corresponding to sequentially selected semiconductor cell (20, 31) of the shared semiconductor cells.

10. The neural network circuit (35, 45) according to claim 9, furthermore comprising a plurality of post-processing units (37) for further processing of the output signals of the accumulation units (36).

11. A neural network circuit (45) according to any of claims 9 or 10, wherein at least two semiconductor cells (20, 31) sharing a single sensing unit (SU) are grouped into an enlarged semiconductor unit (51), the output ports (225) of the at least two semiconductor cells (20) being connected to a switch element (52, 54), the output of the switch element being connected to the single sensing unit (SU).

12. A neural network circuit (45) according to claim 11, wherein the switch element (52, 54) is adapted for allowing multi-bit accumulation of the multiplication result of the at least two semiconductor cells grouped into the enlarged semiconductor unit (51).

13. A neural network circuit (45) according to claim 12, wherein the switch element (52, 80) comprises a first transistor (T1) with a first control electrode and a first and second main electrode and a second transistor (T2) with a second control electrode and a third and fourth main electrode, the first and third main electrode being coupled together to a first reference voltage, and the second and fourth main electrode being coupled together to the sensing unit (SU), wherein an output signal of a first semiconductor cell (20) of the at least two grouped semiconductor cells is coupled to the first control electrode, and an output of a second semiconductor cell (20) of the at least two grouped semiconductor cells is coupled to the second control electrode.

14. A neural network circuit (45) according to claim 13, wherein the switch element (80) furthermore comprises a third transistor (T3) with a third control electrode and a fifth and sixth main electrode and a fourth transistor (T4) with a fourth control electrode and a seventh and eighth main electrode coupled in series whereby the sixth main electrode is connected to the seventh main electrode, the fifth main electrode is coupled with the first and third main electrodes, and the eighth main electrode is coupled with the second and fourth main electrodes, the output of the first semiconductor cell (20) being coupled to the third control electrode, and the output of the second semiconductor cell (20) being coupled to the fourth control electrode.

15. Use of a neural network according to any of claims 9 to 14 for performing a clustering, classification or pattern recognition task.

**Patentansprüche**

1. Halbleiterzelle zum Berechnen in einem Array (30), welches eine Vielzahl von Halbleiterzellen umfasst, wobei die Halbleiterzelle (20, 31) ein Speicherelement (21) zum Speichern eines ersten binären Operanden umfasst, wobei das Speicherelement (21) komplementäre Speicherausgaben (Q, Qbar) bereitstellt, und
einen Multiplikationsblock (22), welcher lokal und eindeutig mit dem Speicherelement (21) verknüpft ist, wobei der Multiplikationsblock (22) zum Empfangen von komplementären Eingangssignalen (X, Xbar), welche binäre Eingangsdaten darstellen und die komplementären Speicherausgaben (Q, Qbar) des verknüpften Speicherelements (21) den ersten binären Operanden darstellen, und zum Implementieren eines Multiplikationsvorgangs für diese Signale konfiguriert ist, und eine Ausgabe des Multiplikationsvorgangs für einen Ausgabeanschluss (225) bereitstellt, wobei der Ausgabeanschluss mit einer Lesebitleitung (RBL) des Arrays wirksam verbindbar ist, um die Ausgabe des Multiplikationsvorgangs von dem Ausgabeanschluss mit der Lesebitleitung zu koppeln.

2. Halbleiterzelle (20, 31) nach Anspruch 1, wobei der Multiplikationsblock (22) adaptiert ist, um eine logische XNOR- oder XOR-Funktion zwischen den Eingangsdaten (X, Xbar) und dem gespeicherten ersten binären Operanden (Q, Qbar) auszuführen.

3. Halbleiterzelle (31) nach einem der vorstehenden Ansprüche, weiter einen Auswahlschalter (32) zum Steuern von Beistellung der Ausgabe des Multiplikationsvorgangs für einen externen Schaltkreis umfassend.

4. Halbleiterzelle (20, 31) nach einem der vorstehenden Ansprüche, wobei das Speicherelement (21) in einer SRAM-Implementierung implementiert ist.

5. Halbleiterzelle (20, 31) nach einem der vorstehenden Ansprüche, wobei das Speicherelement (21) weiter zumindest einen Eingang zum Empfangen des ersten binären Operanden von einer Datenleitung (BL, BLbar) und zumindest einen Zugriffsschalter (38), welcher den zumindest einen Eingang mit einer Speichereinheit (34) der Speicherzelle (21) verbindet, umfasst, wobei der zumindest eine Zugriffsschalter (38) adaptiert ist, um durch eine Wortleitung (WL) angesteuert zu werden, um den ersten binären Operanden an die Speicherzelle (34) weiterzuleiten.

6. Halbleiterzelle (20, 31) nach Anspruch 5 mit zwei Zugriffsschaltern (38), welche zwei Eingänge mit einer Speichereinheit (34) verbinden, um komplementäre Daten des ersten binären Operanden für die Speichereinheit (34) bereitzustellen.

7. Array (30) von Halbleiterzellen (20, 31) nach einem der vorstehenden Ansprüche, welche logisch in Reihen und Spalten angeordnet sind und Wortleitungen entlang der Reihen des Arrays und Bitleitungen entlang der Spalten davon aufweisen, wobei die Kreuzung eines Satzes von Wortleitungen und Bitleitungen einen Ort einer Halbleiterzelle (20, 31) in dem Array (30) eindeutig identifiziert.

8. Array (30) nach Anspruch 7, umfassend Wortleitungen, welche zum Liefern von komplementären Eingangsaktivierungen (X, Xbar) an Eingangsanschlüsse (223, 224) der Halbleiterzellen (20) konfiguriert sind, und umfassend Lesebitleitungen (RBL), welche zum Empfangen der Ausgaben (Out) der Multiplikationsvorgänge aus den Ausleseanschlüssen (225) der Halbleiterzellen (20) in dem Array (30), welches mit dieser Lesebitleitung (RBL) verbunden ist, konfiguriert sind.

9. Neuronale Netzwerkschaltung (35, 45), umfassend zumindest ein Array (30) von Halbleiterzellen (20, 31) nach einem der Ansprüche 7 bis 8 und eine Vielzahl von Sensoreinheiten (SU), wobei jede Sensoreinheit (SU) zwischen unterschiedlichen Halbleiterzellen (20, 31) von zumindest einer Spalte des zumindest einen Arrays (30) geteilt wird, zum Lesen der Ausgaben der Multiplikationsblöcke (22) der geteilten Halbleiterzellen (20, 31), und eine Vielzahl von Akkumulationseinheiten (36), wobei jede Akkumulationseinheit angeordnet ist, um die Ausgaben einer bestimmten Sensoreinheit (SU), welche einer nacheinander ausgewählten Halbleiterzelle (20, 31) der geteilten Halbleiterzellen zugehörig ist, nacheinander zu akkumulieren.

10. Neuronale Netzwerkschaltung (35, 45) nach Anspruch 9, weiter eine Vielzahl von Nachverarbeitungseinheiten (37) zum weiteren Verarbeiten der Ausgabesignale der Akkumulationseinheiten (36) umfassend.

11. Neuronale Netzwerkschaltung (45) nach einem der Ansprüche 9 oder 10, wobei zumindest zwei Halbleiterzellen (20, 31), welche eine einzelne Sensoreinheit (SU) teilen, in eine vergrößerte Halbleitereinheit (51) gruppiert sind, wobei die Ausgabeanschlüsse (225) der zumindest zwei Halbleiterzellen (20) mit einem Schaltelement (52, 54) verbunden sind, wobei die Ausgabe des Schaltelements mit der einzelnen Sensoreinheit (SU) verbunden ist.

**12.** Neuronale Netzwerkschaltung (45) nach Anspruch 11, wobei das Schaltelement (52, 54) adaptiert ist, um Multi-Bit-Akkumulation des Multiplikationsergebnisses der zumindest zwei Halbleiterzellen, welche in die vergrößerte Halbleitereinheit (51) gruppiert sind, zu erlauben.

**13.** Neuronale Netzwerkschaltung (45) nach Anspruch 12, wobei das Schaltelement (52, 80) einen ersten Transistor (T1) mit einer ersten Steuerelektrode und einer ersten und zweiten Hauptelektrode und einen zweiten Transistor (T2) mit einer zweiten Steuerelektrode und einer dritten und vierten Hauptelektrode umfasst, wobei die erste und dritte Hauptelektrode an eine erste Referenzspannung zusammengekoppelt sind, und die zweite und vierte Hauptelektrode an die Sensoreinheit (SU) zusammengekoppelt sind, wobei ein Ausgabesignal einer ersten Halbleiterzelle (20) der zumindest zwei gruppierten Halbleiterzellen an die erste Steuerelektrode gekoppelt ist, und eine Ausgabe einer zweiten Halbleiterzelle (20) der zumindest zwei gruppierten Halbleiterzellen an die zweite Steuerelektrode gekoppelt ist.

**14.** Neuronale Netzwerkschaltung (45) nach Anspruch 13, wobei das Schaltelement (80) weiter einen dritten Transistor (T3) mit einer dritten Steuerelektrode und einer fünften und sechsten Hauptelektrode und eine vierten Transistor (T4) mit einer vierten Steuerelektrode und einer siebenten und achten, in Serie gekoppelten Hauptelektrode umfasst, wobei die sechste Hauptelektrode mit der siebenten Hauptelektrode verbunden ist, die fünfte Hauptelektrode an die erste und dritte Hauptelektrode gekoppelt ist, und die achte Hauptelektrode an die zweite und vierte Hauptelektrode gekoppelt ist, wobei die Ausgabe der ersten Halbleiterzelle (20) an die dritte Steuerelektrode gekoppelt ist, und die Ausgabe der zweiten Halbleiterzelle (20) an die vierte Steuerelektrode gekoppelt ist.

**15.** Nutzung eines neuronalen Netzwerks nach einem der Ansprüche 9 bis 14 zum Durchführen eines Clustering-, einer Klassifizierungs- oder Mustererkennungsaufgabe.

**Revendications**

**1.** Cellule semi-conductrice destinée à un calcul informatique dans un réseau (30) comprenant une pluralité de cellules semi-conductrices, la cellule semi-conductrice (20, 31) comprenant
un élément de mémoire (21) destiné à stocker un premier opérande binaire, lequel élément de mémoire (21) fournit des sorties de mémoire complémentaires (Q, Qbar), et
un bloc de multiplication (22) qui est associé de manière locale et unique à l'élément de mémoire (21), le bloc de multiplication (22) étant configuré pour recevoir des signaux d'entrée complémentaires (X, Xbar) représentant des données d'entrée binaires et les sorties de mémoire complémentaires (Q, Qbar) de l'élément de mémoire associé (21) représentant le premier opérande binaire, et pour mettre en œuvre une opération de multiplication sur ces signaux, et fournir une sortie de l'opération de multiplication à un port de sortie (225), le port de sortie pouvant être connecté fonctionnellement à une ligne de bits de lecture (RBL) du réseau pour le couplage de la sortie de l'opération de multiplication provenant du port de sortie à la ligne de bits de lecture.

**2.** Cellule semi-conductrice (20, 31) selon la revendication 1, dans laquelle le bloc de multiplication (22) est adapté pour réaliser une fonction logique NON OU EXCLUSIF ou OU EXCLUSIF entre les données d'entrée (X, Xbar) et le premier opérande binaire (Q, Qbar) stocké.

**3.** Cellule semi-conductrice (31) selon l'une quelconque des revendications précédentes, comprenant en outre un commutateur de sélection (32) destiné à commander la fourniture de la sortie de l'opération de multiplication à un circuit externe.

**4.** Cellule semi-conductrice (20, 31) selon l'une quelconque des revendications précédentes, dans laquelle l'élément de mémoire (21) est mis en œuvre dans une mise en œuvre SRAM.

**5.** Cellule semi-conductrice (20, 31) selon l'une quelconque des revendications précédentes, dans laquelle l'élément de mémoire (21) comprend en outre au moins une entrée destinée à recevoir le premier opérande binaire depuis une ligne de données (BL, BLbar) et au moins un commutateur d'accès (38) connectant l'au moins une entrée à une unité de mémoire (34) de la cellule de mémoire (21), l'au moins un commutateur d'accès (38) étant adapté pour être piloté par une ligne de mots (WL) destinée à faire passer le premier opérande binaire à l'unité de mémoire (34).

**6.** Cellule semi-conductrice (20, 31) selon la revendication 5, ayant deux commutateurs d'accès (38) connectant deux entrées à une unité de mémoire (34), destinés à fournir des données complémentaires du premier opérande binaire à l'unité de mémoire (34).

**7.** Réseau (30) de cellules semi-conductrices (20, 31) selon l'une quelconque des revendications précédentes, agencé logiquement en rangées et colonnes, et comprenant des lignes de mots le long des rangées du réseau et des lignes de bits le long de ses colonnes, le croisement d'un ensemble de lignes de mots et de lignes de bits identifiant de manière unique un emplacement d'une cellule semi-conductrice (20, 31) dans le réseau (30).

8. Réseau (30) selon la revendication 7, comprenant des lignes de mots configurées pour délivrer des activations d'entrée complémentaires (X, Xbar) à des ports d'entrée (223, 224) des cellules semi-conductrices (20), et comprenant des lignes de bits de lecture (RBL) configurées pour recevoir les sorties (Out) des opérations de multiplication depuis les ports de lecture (225) des cellules semi-conductrices (20) dans le réseau (30) connecté à cette ligne de bits de lecture (RBL).

9. Circuit de réseau neuronal (35, 45) comprenant au moins un réseau (30) de cellules semi-conductrices (20, 31) selon l'une quelconque des revendications 7 à 8, et une pluralité d'unités de captation (SU), chaque unité de captation (SU) étant partagée entre des cellules semi-conductrices (20, 31) différentes d'au moins une colonne de l'au moins un réseau (30), destinées à lire les sorties des blocs de multiplication (22) des cellules semi-conductrices (20, 31) partagées, et une pluralité d'unités d'accumulation (36), chaque unité d'accumulation étant agencée pour accumuler séquentiellement les sorties d'une unité de captation (SU) particulière correspondant à la cellule semi-conductrice (20, 31) sélectionnée séquentiellement des cellules semi-conductrices partagées.

10. Circuit de réseau neuronal (35, 45) selon la revendication 9, comprenant en outre une pluralité d'unités de post-traitement (37) destinées à traiter davantage les signaux de sortie des unités d'accumulation (36).

11. Circuit de réseau neuronal (45) selon l'une quelconque des revendications 9 ou 10, dans lequel au moins deux cellules semi-conductrices (20, 31) partageant une unité de captation (SU) unique sont groupées en une unité semi-conductrice agrandie (51), les ports de sortie (225) des au moins deux cellules semi-conductrices (20) étant connectés à un élément de commutation (52, 54), la sortie de l'élément de commutation étant connectée à l'unité de captation (SU) unique.

12. Circuit de réseau neuronal (45) selon la revendication 11, dans lequel l'élément de commutation (52, 54) est adapté pour permettre une accumulation binaire multiple du résultat de multiplication des au moins deux cellules semi-conductrices groupées en l'unité semi-conductrice agrandie (51).

13. Circuit de réseau neuronal (45) selon la revendication 12, dans lequel l'élément de commutation (52, 80) comprend un premier transistor (T1) avec une première électrode de commande et des première et deuxième électrodes principales et un deuxième transistor (T2) avec une deuxième électrode de commande et des troisième et quatrième électrodes principales, les première et troisième électrodes principales étant couplées ensemble à une première tension de référence, et les deuxième et quatrième électrodes principales étant couplées ensemble à l'unité de captation (SU), dans lequel un signal de sortie d'une première cellule semi-conductrice (20) des au moins deux cellules semi-conductrices groupées est couplé à la première électrode de commande, et une sortie d'une seconde cellule semi-conductrice (20) des au moins deux cellules semi-conductrices groupées est couplée à la deuxième électrode de commande.

14. Circuit de réseau neuronal (45) selon la revendication 13, dans lequel l'élément de commutation (80) comprend en outre un troisième transistor (T3) avec une troisième électrode de commande et des cinquième et sixième électrodes principales et un quatrième transistor (T4) avec une quatrième électrode de commande et des septième et huitième électrodes principales couplées en série selon lequel la sixième électrode principale est connectée à la septième électrode principale, la cinquième électrode principale est couplée aux première et troisième électrodes principales, et la huitième électrode principale est couplée aux deuxième et quatrième électrodes principales, la sortie de la première cellule semi-conductrice (20) étant couplée à la troisième électrode de commande, et la sortie de la seconde cellule semi-conductrice (20) étant couplée à la quatrième électrode de commande.

15. Utilisation d'un réseau neuronal selon l'une quelconque des revendications 9 à 14 destiné à réaliser une tâche de regroupement en grappes, de classification ou de reconnaissance de motif.

FIG. 1 – prior art

FIG. 2

FIG. 3

EP 3 506 084 B1

FIG. 4

FIG. 5

FIG. 6

EP 3 506 084 B1

FIG. 7

FIG. 8

FIG. 9

FIG. 10

EP 3 506 084 B1

FIG. 11

50

51

RBL

MEXN2

20

20

52

51

51

51

SU

FIG. 12

BL   BLbar   RBL

WL0

WL1

RWL

X0

Xbar0

X1

Xbar1

MEXN2

FIG. 13

FIG. 14

FIG. 15

EP 3 506 084 B1

FIG. 16

EP 3 506 084 B1

FIG. 17

FIG. 18

EP 3 506 084 B1

FIG. 19

FIG. 20

FIG. 21

**EP 3 506 084 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5391938 A, Hatsuda, T.